# EUROPÄISCHE PATENTSCHRIFT

(11) **EP 3 734 298 B1**
(45) Veröffentlichungstag und Bekanntmachung des Hinweises auf die Patenterteilung: **28.06.2023**
(21) Anmeldenummer: 19172506.8
(22) Anmeldetag: 03.05.2019
(51) Int. Cl.: G01R 15/20, G01R 19/00

(54) **MESSANORDNUNG ZUM ERFASSEN EINES ELEKTRISCHEN STROMS**
MEASURING ASSEMBLY FOR MEASURING AN ELECTRICAL CURRENT
DISPOSITIF DE MESURE PERMETTANT DE DÉTECTER UN COURANT ÉLECTRIQUE

(43) Veröffentlichungstag der Anmeldung: 04.11.2020
(73) Patentinhaber: Siemens Aktiengesellschaft, 80333 München (DE)
(72) Erfinder: Behringer, Klaus, 91338 Igensdorf (DE); Burger, Josef, 92546 Schmidgaden (DE); Bär, Thomas, 92260 Fichtenhof (DE); Lehmeier, Annemarie, 92289 Ursensollen (DE); Meier, Matthias, 92284 Poppenricht (DE)
(74) Vertreter: Siemens Patent Attorneys

(56) Entgegenhaltungen:
- WO-A1-2011/090167
- DE-A1-102014 106 816
- JP-A- H03 272 476
- US-A1- 2010 259 255
- US-A1- 2015 309 080

## Beschreibung

Die Erfindung betrifft eine Messanordnung zum Erfassen eines elektrischen Stroms.

In technischen Anlagen, Schaltschränken, Einschüben oder Gebäudeautomatisierungen werden Kabel oder Stromschienen zur Energieverteilung verwendet. Steigendes Umweltbewusstsein und wachsende Energiekosten erfordern eine Vermeidung von Energieverschwendung und speziell eine effiziente Nutzung elektrischer Energie. Das hierfür erforderliche "Energiemanagement" benötigt als Eingangsgröße eine detaillierte Überwachung der Energieverteilung. Hierbei sind insbesondere die Energieflüsse zu den an ein elektrisches Energieversorgungsnetz angeschlossenen Verbrauchern von Interesse. Um das Energiemanagement betreiben zu können, müssen insbesondere elektrische Ströme erfasst werden, die in elektrischen Leitungen zwischen den Verbrauchern und dem Energieversorgungsnetz fließen. Für die Strommessung werden gegenwärtig häufig Ringkernwandler verwendet. Ringkernwandler benötigen jedoch einen relativ großen Bauraum und können keine Gleichströme erfassen.

DE 10 2010 043 254 A1 offenbart ein Messsystem zur Überwachung mindestens einer Phase eines Systems mit einem auf einer Leiterplatte angeordneten Messmodul, das einen Signalerfassungsbaustein und einen Signalweiterverarbeitungsbaustein aufweist. Die Leiterplatte weist einen Spannungssensor für jede zu überwachende Phase auf und der Signalerfassungsbaustein weist Stromsensoren für jede zu überwachende Phase auf.

US 2015/309080 A1 offenbart eine hybride Stromsensoranordnung mit einem Messwiderstand, der an einem zentralen Abschnitt eines Leiters positioniert ist, und ein Mikroprozessor ist mit einem Messwiderstandsanschluss verbunden, um den Strom im Leiter zu messen. Die Positionierung der Sammelschiene in Bezug auf den Stromsensor erfolgt durch die Messwiderstandsanschlüsse und zusätzlich durch die Hall-Kern-Einsätze in den Nuten der Stromsensor-Leiterplatte.

US 2010/259255 A1 offenbart eine Stromerfassungsvorrichtung, die in einem Fahrzeug angeordnet ist und ein Gehäuse, eine Sensoreinheit, eine Sammelschiene, ein Magnetabschirmungselement und eine untere Abdeckung umfasst. Die untere Abdeckung ist mit Schrauben an dem Gehäuse befestigt, um die Sammelschiene und das Magnetabschirmelement dazwischen zu umschließen.

Der Erfindung liegt die Aufgabe zugrunde, eine kompakte und flexibel einsetzbare Messanordnung zum Erfassen eines in einem elektrischen Leiter fließenden elektrischen Stroms anzugeben, mit der insbesondere auch Gleichströme erfasst werden können.

Die Aufgabe wird erfindungsgemäß durch eine Messanordnung mit den Merkmalen des Anspruchs 1 gelöst.

Vorteilhafte Ausgestaltungen der Erfindung sind Gegenstand der Unteransprüche.

Eine erfindungsgemäße Messanordnung zum Erfassen eines in einem elektrischen Leiter fließenden elektrischen Stroms umfasst den Leiter, eine Leiterplatte, eine an der Leiterplatte angeordnete Strommesseinheit, die wenigstens zwei Stromsensoren aufweist, und ein Positionierelement zum Positionieren des Leiters an einer ersten Leiterplattenoberfläche der Leiterplatte. Das Positionierelement ist mit der Leiterplatte verbindbar und weist eine zu einem Leiterabschnitt des Leiters korrespondierende Nut auf, in der der Leiterabschnitt formschlüssig an der ersten Leiterplattenoberfläche anordenbar ist. Dabei ist die Strommesseinheit an einer der ersten Leiterplattenoberfläche gegenüberliegenden zweiten Leiterplattenoberfläche der Leiterplatte angeordnet. Dadurch wirkt die Leiterplatte als ein Isolator, der den Leiter von der Strommesseinheit elektrisch isoliert und den Abstand der Strommesseinheit von dem Leiter definiert.

Die Messanordnung ermöglicht eine einfache und genaue Positionierung der Strommesseinheit relativ zu dem Leiter. Dabei dient das Positionierelement zum genauen Positionieren des Leiters an der Leiterplatte, wobei die Nut des Positionierelements die Position des Leiters festlegt.

Bei einer Ausgestaltung der Erfindung weist die Leiterplatte wenigstens eine Leiterplattenöffnung auf und das Positionierelement weist wenigstens eine zu einer Leiterplattenöffnung korrespondierende Aussparung auf, in der zum Verbinden des Positionierelements mit der Leiterplatte ein durch die Leiterplattenöffnung geführtes Verbindungselement kraftschlüssig oder/und formschlüssig fixierbar ist. Beispielsweise ist jede Aussparung des Positionierelements von einem Kragen berandet, der in die Leiterplattenöffnung, zu der die Aussparung korrespondiert, einführbar ist. Ferner können an jedem eine Aussparung berandenden Kragen verformbare Kragenrippen angeordnet sein, die beim Verbinden des Positionierelements mit der Leiterplatte von einem die Leiterplattenöffnung, zu der die Aussparung korrespondiert, berandenden Öffnungsrand der Leiterplatte verformt werden.

Die wenigstens eine Leiterplattenöffnung und die dazu korrespondierende Aussparung in dem Positionierelement ermöglichen vorteilhaft ein festes Verbinden des Positionierelements mit der Leiterplatte durch ein in der Aussparung fixiertes Verbindungselement. Der in die Leiterplattenöffnung ragende Kragen erleichtert dabei die Positionierung des Positionierelements an der Leiterplatte. Die an einem Kragen angeordneten Kragenrippen gleichen Unterschiede der Querschnitte der Leiterplattenöffnung und des Kragen aus, indem sie bei dem Verbinden des Positionierelements mit der Leiterplatte verformt werden und danach an dem Öffnungsrand der Leiterplattenöffnung anliegen.

Vorzugsweise ist die Strommesseinheit in einem Bereich der Leiterplatte angeordnet, an dem der Leiter positioniert wird. Die Stromsensoren sind beispielsweise Magnetfelder detektierende Sensoren, insbesondere Hall-Sensoren. Die Anordnung der Strommesseinheit in der Nähe des Leiters ermöglicht Messsignale ausreichender Stärke am Ort der Stromsensoren. Dies ist insbesondere bei der Verwendung von Magnetfelder detektierenden Sensoren vorteilhaft, da diese den Strom über ein von dem Strom erzeugtes Magnetfeld erfassen, dessen Stärke mit dem Abstand vom Leiter schnell abnimmt.

Bei einer weiteren Ausgestaltung der Erfindung sind an einem Nutgrund der Nut verformbare Nutgrundrippen angeordnet, die beim Verbinden des Positionierelements mit der Leiterplatte von dem in der Nut positionierten Leiterabschnitt des Leiters verformt werden. Die Nutgrundrippen an dem Nutgrund der Nut gleichen Unterschiede der Querschnitte der Nut und des Leiterabschnitts aus, indem sie beim Verbinden des Positionierelements mit der Leiterplatte verformt werden und danach an dem Leiterabschnitt anliegen.

Bei einer weiteren Ausgestaltung der Erfindung weist die Nut in dem Positionierelement an jedem Nutende eine größere Nuttiefe als in einem zwischen den Nutenden verlaufenden Nutmittelbereich auf und der Leiterabschnitt des Leiters weist eine zu der Nuttiefe korrespondierende Leiterabschnittshöhe auf, die der Nuttiefe entsprechend an jedem Leiterabschnittende größer als in einem zwischen den Leiterabschnittenden verlaufenden Leiterabschnittmittelbereich ist. Dies ermöglicht eine genaue Positionierung des Leiterabschnitts an dem Positionierelement und einen Formschluss des Leiterabschnitts mit dem Positionierelement durch die zueinander korrespondierenden Geometrien der Nut und des Leiterabschnitts.

Bei einer weiteren Ausgestaltung der Erfindung weist das Positionierelement in einem sich an ein Nutende der Nut anschließenden Bereich einen Positionierzapfen auf, der zu einer Leiterausnehmung in dem Leiter korrespondiert und in die Leiterausnehmung hineinragt, wenn der Leiterabschnitt des Leiters in der Nut angeordnet ist. Die Leiterausnehmung und der Positionierzapfen bilden eine weitere Positionierungshilfe zum Positionieren des Leiters.

Bei einer weiteren Ausgestaltung der Erfindung weisen die Nut und der Leiterabschnitt jeweils einen rechteckigen Querschnitt auf. Dadurch haben der Leiterabschnitt und die Nut einfache geometrische Formen, die insbesondere ihre passgenaue Herstellung erleichtern.

Bei einer weiteren Ausgestaltung der Erfindung ist an oder in der Leiterplatte ein Spannungssensor angeordnet, der zum Erfassen einer an dem Leiter anliegenden elektrischen Spannung eingerichtet ist. Dadurch ermöglicht die Messanordnung vorteilhaft auch die Überwachung einer an dem Leiter anliegenden Spannung.

Bei einer weiteren Ausgestaltung der Erfindung weist die Messanordnung eine magnetische Abschirmung auf. Dadurch können vorteilhaft Magnetfelder abgeschirmt werden, die die Strommessung stören können.

Bei einer weiteren Ausgestaltung der Erfindung weist die Messanordnung eine elektrische Abschirmung auf, die in der Leiterplatte zwischen der Strommesseinheit und der für den Leiter vorgesehenen Position angeordnet ist. Dadurch können vorteilhaft elektrische Felder abgeschirmt werden, die die Strommessung stören können.

Bei einer weiteren Ausgestaltung der Erfindung weist die Messanordnung eine Messsignalverarbeitungseinheit auf, die dazu eingerichtet ist, von der Strommesseinheit erfasste Messsignale zu verarbeiten. Dadurch können die von der Strommesseinheit erfassten Messsignalen von der Messanordnung ausgewertet werden, beispielsweise um Überströme oder Kurzschlussströme zu signalisieren.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
FIG 1 eine Querschnittdarstellung eines Ausführungsbeispiels einer erfindungsgemäßen Messanordnung während deren Montage,
FIG 2 eine Längsschnittdarstellung der in Figur 1 gezeigten Messanordnung während deren Montage,
FIG 3 eine Querschnittdarstellung der in den Figuren 1 und 2 gezeigten Messanordnung nach deren Montage,
FIG 4 eine perspektivische Darstellung des elektrischen Leiters der in den Figuren 1 bis 3 gezeigten Messanordnung,
FIG 5 eine perspektivische Darstellung des Positionierelements der in den Figuren 1 bis 3 gezeigten Messanordnung,
FIG 6 eine perspektivische Darstellung eines Bereichs des in Figur 5 gezeigten Positionierelements,
FIG 7 eine Draufsicht auf das in Figur 5 gezeigte Positionierelement im Bereich einer Aussparung,
FIG 8 eine Leiterplattenöffnung in der Leiterplatte und eine dazu korrespondierende Aussparung in dem Positionierelement der in den Figuren 1 bis 3 gezeigten Messanordnung.

Einander entsprechende Teile sind in den Figuren mit denselben Bezugszeichen versehen.

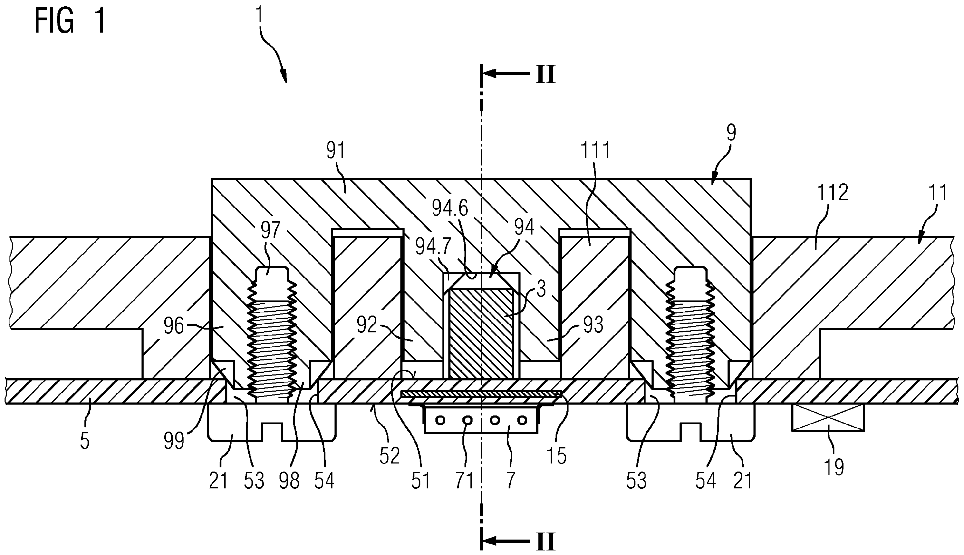

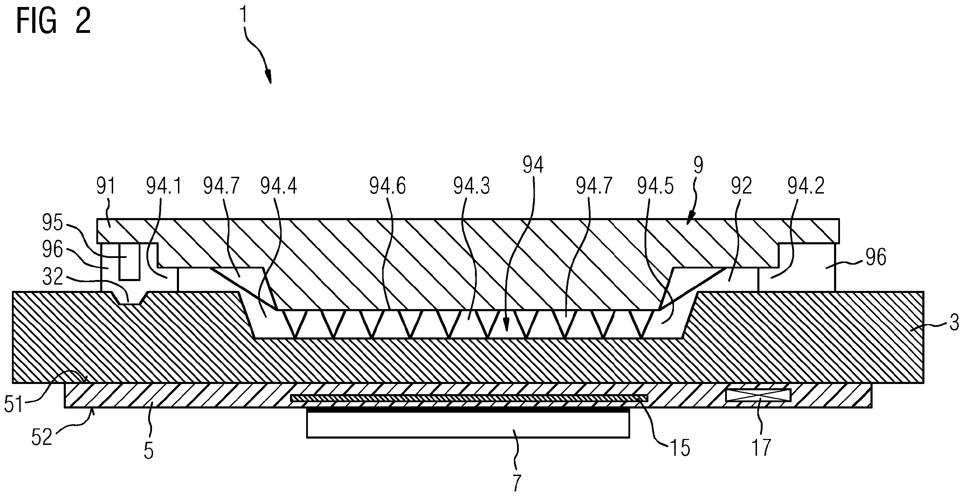

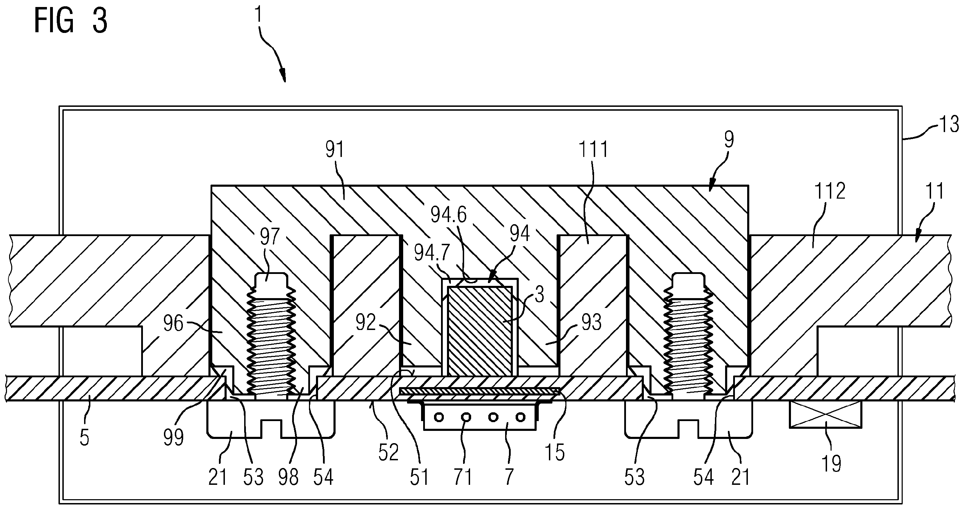

Die Figuren 1 bis 3 zeigen jeweils eine Schnittdarstellung eines Ausführungsbeispiels einer erfindungsgemäßen Messanordnung 1 zum Erfassen eines in einem elektrischen Leiter 3 fließenden elektrischen Stroms, wobei die Messanordnung 1 in den Figuren 1 und 2 während deren Montage und in Figur 3 nach der Montage gezeigt ist. Figur 1 und 3 zeigen jeweils eine Querschnittdarstellung der Messanordnung 1 in einer Schnittebene senkrecht zu einer Längsachse des Leiters 3. Figur 2 zeigt eine Längsschnittdarstellung der Messanordnung 1 und des Leiters 3 in einer Schnittebene, die die Längsachse des Leiters 3 enthält.

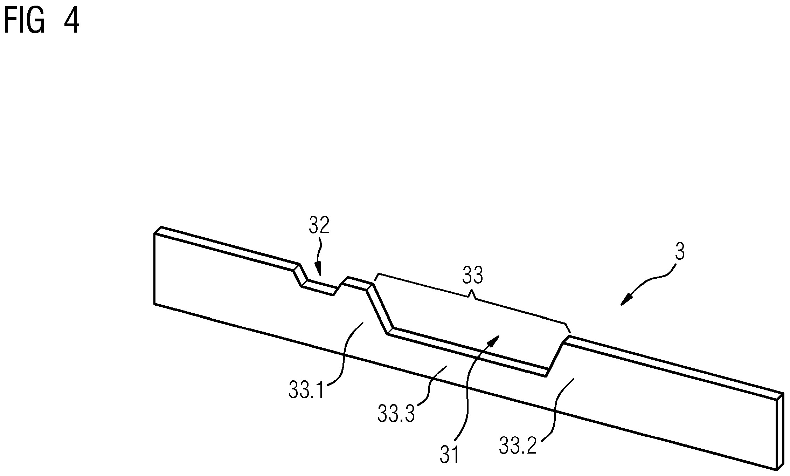

Figur 4 zeigt eine perspektivische Darstellung des Leiters 3.

Die Messanordnung 1 umfasst den Leiter 3, eine Leiterplatte 5, eine Strommesseinheit 7, ein Positionierelement 9, einen Halter 11, eine magnetische Abschirmung 13, eine elektrische Abschirmung 15, einen Spannungssensor 17 und eine Messsignalverarbeitungseinheit 19.

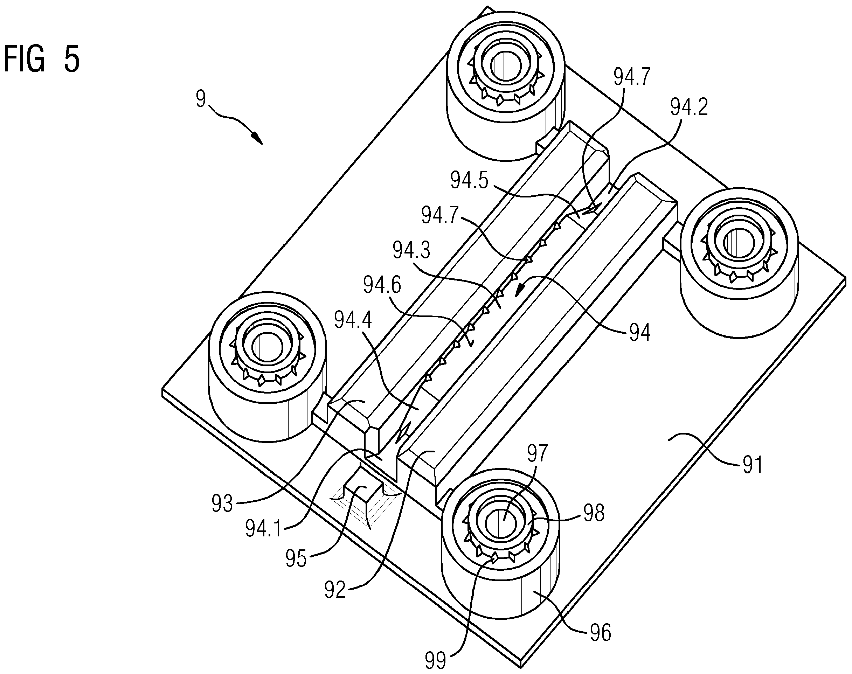

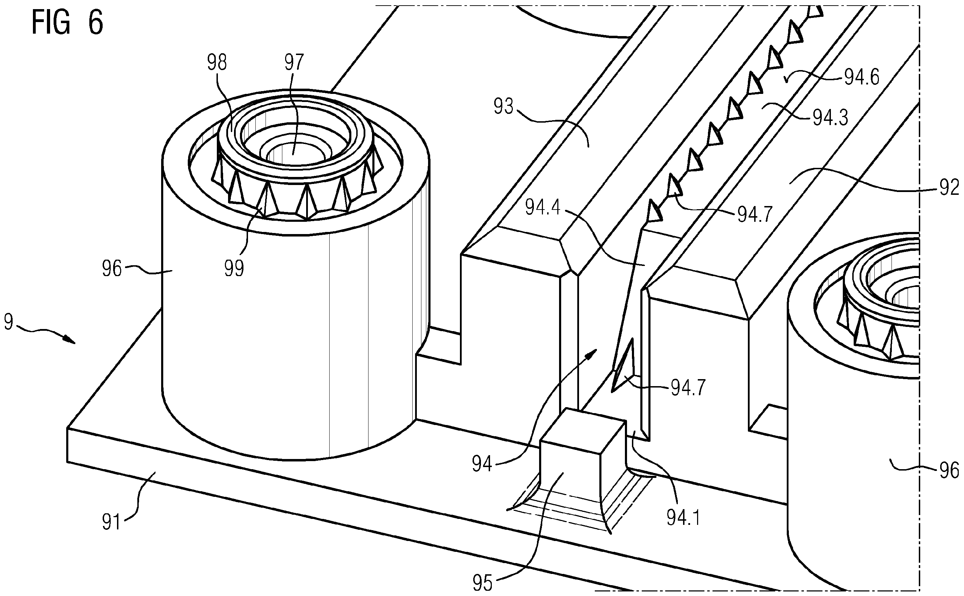

Die Figuren 5 und 6 zeigen perspektivische Darstellungen des Positionierelements 9, wobei Figur 6 nur einen Teilbereich des Positionierelements 9 zeigt.

Der Leiter 3 wird an einer ersten Leiterplattenoberfläche 51 der Leiterplatte 5 positioniert. Die Strommesseinheit 7 ist an einer der ersten Leiterplattenoberfläche 51 gegenüberliegenden zweiten Leiterplattenoberfläche 52 der Leiterplatte 5 in einem Bereich der Leiterplatte 5, in dem der Leiter 3 positioniert wird, angeordnet. Die elektrische Abschirmung 15 ist in der Leiterplatte 5 zwischen der Strommesseinheit 7 und dem Leiter 3 angeordnet.

Die Leiterplatte 5 weist vier Leiterplattenöffnungen 53 auf, durch die jeweils ein Verbindungselement 21 geführt wird, um die Leiterplatte 5 mit dem Positionierelement 9 zu verbinden.

Die Strommesseinheit 7 weist mehrere (in dem dargestellten Ausführungsbeispiel vier) Stromsensoren 71 auf, die beispielsweise als Magnetfelder detektierende Sensoren, insbesondere als Hall-Sensoren ausgebildet sind. Die Strommesseinheit 7 ist dazu eingerichtet, einen in dem Leiter 3 fließenden elektrischen Strom zu erfassen. Beispielsweise ist die Strommesseinheit 7 als eine anwendungsspezifische integrierte Schaltung (Application-Specific Integrated Circuit, ASIC) ausgebildet.

Der Spannungssensor 17 ist in der Leiterplatte 5 in einem Bereich, an dem der Leiter 3 positioniert wird, angeordnet. Der Spannungssensor 17 ist beispielsweise als ein kapazitiver Spannungssensor ausgebildet und dazu eingerichtet, eine an dem Leiter 3 anliegende elektrische Spannung gegenüber einem Bezugspotential zu erfassen. Der Spannungssensor 17 kann beispielsweise durch einen direkten elektrischen Kontakt mit dem Leiter 3 verbunden werden. Beispielsweise weist die Leiterplatte 5 dazu ein (nicht dargestelltes) elektrisches Kontaktelement auf, das mit dem Spannungssensor 17 elektrisch verbunden ist und nach der Montage an dem Leiter 3 anliegt.

Alternativ kann der Spannungssensor 17 selbst nach der Montage direkt mit dem Leiter 3 elektrisch verbunden sein. In diesem Fall ist der Spannungssensor 17 nicht wie in Figur 2 gezeigt vollständig in die Leiterplatte 5 eingebettet, sondern weist eine Oberfläche auf, die den Leiter 3 nach der Montage kontaktiert. Insbesondere kann der Spannungssensor 17 aus der Leiterplatte 5 herausragen und der Leiter 3 kann einen Leiterausschnitt (ähnlich wie den Ausschnitt 32 in Figur 4) aufweisen, in den der Spannungssensor 17 nach der Montage hineinragt und an dem der Spannungssensor 17 anliegt.

Eine direkte elektrische Verbindung des Spannungssensors 17 mit dem Leiter 3 ist insbesondere erforderlich, wenn mit dem Spannungssensor 17 Gleichspannungen erfasst werden sollen. Im Fall, dass mit dem Spannungssensor 17 nur Wechselspannungen erfasst werden sollen, ist eine direkte elektrische Verbindung des Spannungssensors 17 mit dem Leiter 3 dagegen nicht unbedingt erforderlich.

Die Strommesseinheit 7 und der Spannungssensor 17 sind über nicht dargestellte, beispielsweise in der Leiterplatte 5 verlaufende elektrische Leitungen mit der Messsignalverarbeitungseinheit 19 verbunden. Die Messsignalverarbeitungseinheit 19 ist dazu eingerichtet, von der Strommesseinheit 7 und dem Spannungssensor 17 erfasste Messsignale zu verarbeiten.

Mit dem Positionierelement 9 wird der Leiter 3 an der Leiterplatte 5 positioniert. Das Positionierelement 9 weist einen plattenförmigen Grundkörper 91 auf, von dem zwei zueinander parallele Wände 92, 93 abstehen, zwischen denen eine Nut 94 verläuft. Die Nut 94 weist an jedem Nutende 94.1, 94.2 eine größere Nuttiefe als in einem zwischen den Nutenden 94.1, 94.2 verlaufenden Nutmittelbereich 94.3 auf, wobei zwischen dem Nutmittelbereich 94.3 und jedem Nutende 94.1, 94.2 ein Übergangsbereich 94.4, 94.5 liegt, in dem ein Nutgrund 94.6 der Nut 94 rampenartig ausgebildet ist. An dem Nutgrund 94.6 der Nut 94 sind mehrere verformbare Nutgrundrippen 94.7 angeordnet.

In einem sich an ein Nutende 94.1 der Nut 94 anschließenden Bereich des Positionierelements 9 steht ein Positionierzapfen 95 von dem Grundkörper 91 ab. Ferner stehen von dem Grundkörper 91 vier hohlzylinderartige Befestigungskörper 96 ab, die jeweils zu einer Leiterplattenöffnung 53 der Leiterplatte 5 korrespondieren und eine Aussparung 97 aufweisen, in der ein durch die Leiterplattenöffnung 53 geführtes Verbindungselement 21 kraftschlüssig oder/und formschlüssig fixierbar ist. Beispielsweise sind die Verbindungselemente 21 Schrauben mit jeweils einem Außengewinde und die Aussparungen 97 weisen jeweils ein zu dem Außengewinde korrespondierendes Innengewinde auf.

Jede Aussparung 97 ist von einem Kragen 98 berandet, der in die Leiterplattenöffnung 53, zu der die Aussparung 97 korrespondiert, einführbar ist. An jedem eine Aussparung 97 berandenden Kragen 98 sind verformbare Kragenrippen 99 angeordnet, die beim Verbinden des Positionierelements 9 mit der Leiterplatte 5 von einem die Leiterplattenöffnung 53, zu der die Aussparung 97 korrespondiert, berandenden Öffnungsrand 54 der Leiterplatte 5 verformt werden. Die Wände 92, 93, der Positionierzapfen 95 und die Befestigungskörper 96 stehen auf einer Seite von dem Grundkörper 91 ab, die beim Verbinden des Positionierelements 9 mit der Leiterplatte 5 der ersten Leiterplattenoberfläche 51 zugewandt wird.

Das Positionierelement 9 ist vorzugsweise aus einem Kunststoff gefertigt, beispielsweise aus einem Thermoplast (z. B. aus einem Polyamid oder Polycarbonat).

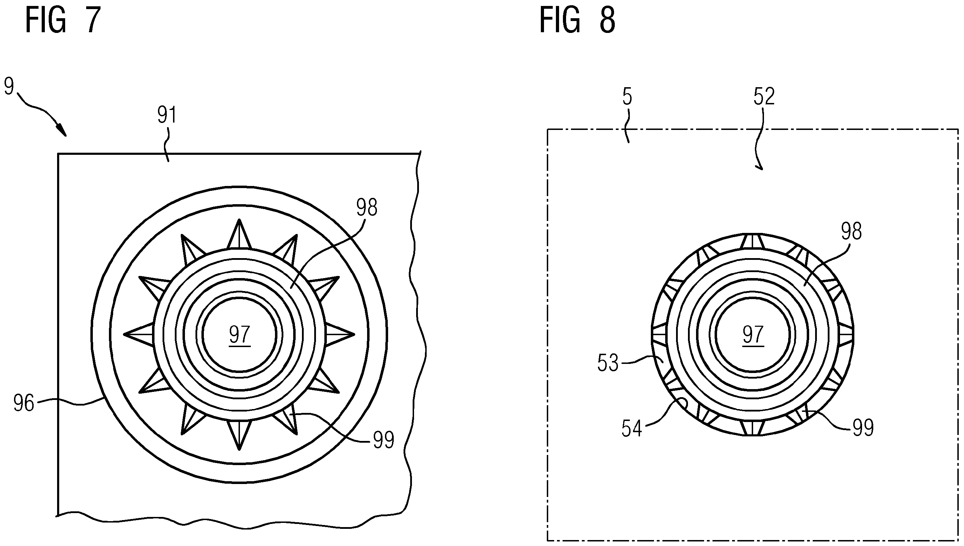

Figur 7 zeigt eine Draufsicht auf das Positionierelement 9 im Bereich eines Befestigungskörpers 96. Figur 8 zeigt den in eine Leiterplattenöffnung 53 hineinragenden Kragen 98 eines Befestigungskörpers 96 mit deformierten Kragenrippen 99.

Der Leiter 3 ist im Wesentlichen als ein länglicher Quader ausgebildet, der an einer Längsseite zwei trapezförmige Ausschnitte 31, 32 aufweist. Ein erster Ausschnitt 31 verläuft in einem Leiterabschnitt 33 des Leiters 3, der in der Nut 94 des Positionierelements 9 angeordnet wird. Die Nut 94 korrespondiert zu dem Leiterabschnitt 33 und bildet nach dem Verbinden des Positionierelements 9 mit der Leiterplatte 5 an der ersten Leiterplattenoberfläche 51 eine Ausnehmung, in der der Leiterabschnitt 33 formschlüssig aufgenommen wird. Der Leiterabschnitt 33 weist eine Leiterabschnittshöhe auf, die der an den Nutenden 94.1, 94.2 größeren Nuttiefe der Nut 94 entsprechend an jedem Leiterabschnittende 33.1, 33.2 größer als in einem zwischen den Leiterabschnittenden 33.1, 33.2 verlaufenden Leiterabschnittmittelbereich 33.3 ist.

Beim Verbinden des Positionierelements 9 mit der Leiterplatte 5 werden die Nutgrundrippen 94.7 an dem Nutgrund 94.6 der Nut 94 verformt und gleichen Unterschiede der Querschnitte der Nut 94 und des Leiterabschnitts 33 aus. Der zweite Ausschnitt 32 bildet eine Leiterausnehmung in dem Leiter 3, zu der der Positionierzapfen 95 korrespondiert und in die der Positionierzapfen 95 hineinragt, wenn der Leiterabschnitt 33 in der Nut 94 positioniert ist.

Der Halter 11 weist einen Mittelbereich 111 und einen Außenbereich 112 auf. Der Mittelbereich 111 wird zwischen der Leiterplatte 5 und dem Positionierelement 9 angeordnet und ist derart gestaltet, dass er durch das Verbinden des Positionierelements 9 mit der Leiterplatte 5 formschlüssig von dem Positionierelement 9 und der Leiterplatte 5 umgeben ist. Der Außenbereich 112 steht nach dem Verbinden des Positionierelements 9 mit der Leiterplatte 5 von dem Positionierelement 9 nach außen ab. Der Halter 11 ist vorzugsweise aus einem Kunststoff gefertigt.

Bei der Montage der Messanordnung 1 werden die Leiterplatte 5, das Positionierelement 9 und der Halter 11 gleichzeitig an dem Leiter 3 positioniert, so dass der Leiter 3 in der Nut 94 angeordnet ist und der Positionierzapfen 95 in die Leiterausnehmung 32 hineinragt. Dann werden die Verbindungselemente 21 jeweils durch eine Leiterplattenöffnung 53 in die dazu korrespondierende Aussparung 97 geführt und in der Aussparung 97 fixiert, wodurch das Positionierelement 9, die Leiterplatte 5 und der Halter 11 miteinander verbunden werden und der Leiterabschnitt 33 formschlüssig mit dem Positionierelement 9 und der Leiterplatte 5 verbunden wird. Anschließend wird die magnetische Abschirmung 13 an dem Halter 11 befestigt. Die Messanordnung 1 wird beispielsweise in einem Schaltschrank montiert.

Die Erfindung wird durch die beigefügten Ansprüche definiert.

## Patentansprüche

1. Messanordnung (1) zum Erfassen eines in einem elektrischen Leiter (3) fließenden elektrischen Stroms, die Messanordnung (1) umfassend
- den Leiter (3),
- eine Leiterplatte (5),
- eine an der Leiterplatte (5) angeordnete Strommesseinheit (7), die wenigstens zwei Stromsensoren (71) aufweist, und
- ein Positionierelement (9) zum Positionieren des Leiters (3) an einer ersten Leiterplattenoberfläche (51) der Leiterplatte (5), wobei
- das Positionierelement (9) mit der Leiterplatte (5) verbindbar ist, **dadurch gekennzeichnet dass** das Positionierelement (9) eine zu einem Leiterabschnitt (33) des Leiters (3) korrespondierende Nut (94) aufweist, in der der Leiterabschnitt (33) formschlüssig an der ersten Leiterplattenoberfläche (51) anordenbar ist, und wobei
- die Strommesseinheit (7) an einer der ersten Leiterplattenoberfläche (51) gegenüberliegenden zweiten Leiterplattenoberfläche (52) der Leiterplatte (5) angeordnet ist und die Leiterplatte (5) als Isolator wirkt, der den Leiter (3) von der Strommesseinheit (7) elektrisch isoliert und den Abstand der Strommesseinheit (7) von dem Leiter (3) definiert.

2. Messanordnung (1) nach Anspruch 1, wobei die Leiterplatte (5) wenigstens eine Leiterplattenöffnung (53) aufweist und das Positionierelement (9) wenigstens eine zu einer Leiterplattenöffnung (53) korrespondierende Aussparung (97) aufweist, in der zum Verbinden des Positionierelements (9) mit der Leiterplatte (5) ein durch die Leiterplattenöffnung (53) geführtes Verbindungselement (21) kraftschlüssig oder/und formschlüssig fixierbar ist.

3. Messanordnung (1) nach Anspruch 2, wobei jede Aussparung (97) des Positionierelements (9) von einem Kragen (98) berandet ist, der in die Leiterplattenöffnung (53), zu der die Aussparung (97) korrespondiert, einführbar ist.

4. Messanordnung (1) nach Anspruch 3, wobei an jedem eine Aussparung (97) berandenden Kragen (98) verformbare Kragenrippen (99) angeordnet sind, die beim Verbinden des Positionierelements (9) mit der Leiterplatte (5) von einem die Leiterplattenöffnung (53), zu der die Aussparung (97) korrespondiert, berandenden Öffnungsrand (54) der Leiterplatte (5) verformt werden.

5. Messanordnung (1) nach einem der vorhergehenden Ansprüche, wobei die Strommesseinheit (7) in einem Bereich der Leiterplatte (5) angeordnet ist, an dem der Leiter (3) positioniert wird.

6. Messanordnung (1) nach einem der vorhergehenden Ansprüche, wobei die Stromsensoren (9) Magnetfelder detektierende Sensoren sind.

7. Messanordnung (1) nach einem der vorhergehenden Ansprüche, wobei an einem Nutgrund (94.6) der Nut (94) verformbare Nutgrundrippen (94.7) angeordnet sind, die beim Verbinden des Positionierelements (9) mit der Leiterplatte (5) von dem in der Nut (94) positionierten Leiterabschnitt (33) des Leiters (3) verformt werden.

8. Messanordnung (1) nach einem der vorhergehenden Ansprüche, wobei die Nut (94) in dem Positionierelement (9) an jedem Nutende (94.1, 94.2) eine größere Nuttiefe als in einem zwischen den Nutenden (94.1, 94.2) verlaufenden Nutmittelbereich (94.3) aufweist und der Leiterabschnitt (33) des Leiters (3) eine zu der Nuttiefe korrespondierende Leiterabschnittshöhe aufweist, die der Nuttiefe entsprechend an jedem Leiterabschnittende (33.1, 33.2) größer als in einem zwischen den Leiterabschnittenden (33.1, 33.2) verlaufenden Leiterabschnittmittelbereich (33.3) ist.

9. Messanordnung (1) nach einem der vorhergehenden Ansprüche, wobei das Positionierelement (9) in einem sich an ein Nutende (94.1) der Nut (94) anschließenden Bereich einen Positionierzapfen (95) aufweist, der zu einer Leiterausnehmung (32) in dem Leiter (3) korrespondiert und in die Leiterausnehmung (32) hineinragt, wenn der Leiterabschnitt (33) des Leiters (3) in der Nut (94) angeordnet ist.

10. Messanordnung (1) nach einem der vorhergehenden Ansprüche, wobei die Nut (94) und der Leiterabschnitt (33) jeweils einen rechteckigen Querschnitt aufweisen.

11. Messanordnung (1) nach einem der vorhergehenden Ansprüche, wobei an oder in der Leiterplatte (5) ein Spannungssensor (17) angeordnet ist, der zum Erfassen einer an dem Leiter (3) anliegenden elektrischen Spannung eingerichtet ist.

12. Messanordnung (1) nach einem der vorhergehenden Ansprüche mit einer magnetischen Abschirmung (13).

13. Messanordnung (1) nach einem der vorhergehenden Ansprüche mit einer elektrischen Abschirmung (15), die in der Leiterplatte (5) zwischen der Strommesseinheit (7) und der für den Leiter (3) vorgesehenen Position angeordnet ist.

14. Messanordnung (1) nach einem der vorhergehenden Ansprüche mit einer Messsignalverarbeitungseinheit (19), die dazu eingerichtet ist, von der Strommesseinheit (7) erfasste Messsignale zu verarbeiten.

## Claims

1. Measuring assembly (1) for detecting an electrical current flowing in an electrical conductor (3), the measuring assembly (1) comprising
- the conductor (3),
- a circuit board (5),
- a current measuring unit (7) which is arranged on the circuit board (5) and which has at least two current sensors (71), and
- a positioning element (9) for positioning the conductor (3) on a first circuit board surface (51) of the circuit board (5), wherein
- the positioning element (9) can be connected to the circuit board (5), **characterized in that** the positioning element (9) has a groove (94) which corresponds to a conductor section (33) of the conductor (3) and in which the conductor section (33) can be arranged in a form-fitting manner on the first circuit board surface (51), wherein
- the current measuring unit (7) is arranged on a second circuit board surface (52) of the circuit board (5), opposite to the first circuit board surface (51), and the circuit board (5) acts as an insulator which insulates the conductor (3) electrically from the current measuring unit (7) and defines the distance of the current measuring unit (7) from the conductor (3).

2. Measuring assembly (1) according to Claim 1, wherein the circuit board (5) has at least one circuit board opening (53) and the positioning element (9) has at least one cut-out (97) corresponding to a circuit board opening (53) and in which, to connect the positioning element (9) to the circuit board (5), a connecting element (21) led through the circuit board opening (53) can be fixed in a force-fitting and/or form-fitting manner.

3. Measuring assembly (1) according to Claim 2, wherein each cut-out (97) of the positioning element (9) is bordered by a collar (98), which can be inserted into the circuit board opening (53) to which the cut-out (97) corresponds.

4. Measuring assembly (1) according to Claim 3, wherein deformable collar ribs (99), which are deformed by an opening edge (54) of the circuit board (5), bordering the circuit board opening (53) to which the cut-out (97) corresponds, as the positioning element (9) is connected to the circuit board (5), are arranged on each collar (98) bordering a cut-out (97).

5. Measuring assembly (1) according to one of the preceding claims, wherein the current measuring unit (7) is arranged in an area of the circuit board (5) on which the conductor (3) is positioned.

6. Measuring assembly (1) according to one of the preceding claims, wherein the current sensors (9) are sensors detecting magnetic fields.

7. Measuring assembly (1) according to one of the preceding claims, wherein deformable groove base ribs (94.7), which are deformed by the conductor section (33) of the conductor (3) that is positioned in the groove (94) as the positioning element (9) is connected to the circuit board (5), are arranged on a groove base (94.6) of the groove (94).

8. Measuring assembly (1) according to one of the preceding claims, wherein the groove (94) in the positioning element (9) has a greater groove depth at each groove end (94.1, 94.2) than in a groove central region (94.3) extending between the groove ends (94.1, 94.2), and the conductor section (33) of the conductor (3) has a conductor section height corresponding to the groove depth which, corresponding to the groove depth, is greater at each conductor section end (33.1, 33.2) than in a conductor section central region (33.3) extending between the conductor section ends (33.1, 33.2).

9. Measuring assembly (1) according to one of the preceding claims, wherein, in a region adjoining a groove end (94.1) of the groove (94), the positioning element (9) has a positioning pin (95), which corresponds to a conductor cut-out (32) in the conductor (3) and projects into the conductor cut-out (32) when the conductor section (33) of the conductor (3) is arranged in the groove (94).

10. Measuring assembly (1) according to one of the preceding claims, wherein the groove (94) and the conductor section (33) each have a rectangular cross section.

11. Measuring assembly (1) according to one of the preceding claims, wherein a voltage sensor (17), which is set up to detect an electrical voltage present on the conductor (3), is arranged on or in the circuit board (5).

12. Measuring assembly (1) according to one of the preceding claims, having a magnetic shield (13).

13. Measuring assembly (1) according to one of the preceding claims, having an electric shield (15), which is arranged in the circuit board (5) between the current measuring unit (7) and the position provided for the conductor (3).

14. Measuring assembly (1) according to one of the preceding claims, having a measured signal processing unit (19), which is set up to process measured signals detected by the current measuring unit (7).

## Revendications

1. Dispositif de mesure (1) destiné à la détection d'un courant électrique circulant dans un conducteur électrique (3), le dispositif de mesure (1) comprenant
- le conducteur (3),
- une carte de circuit imprimé (5),
- une unité de mesure de courant (7) disposée au niveau de la carte de circuit imprimé (5), qui présente au moins deux détecteurs de courant (71), et
- un élément de positionnement (9) destiné au positionnement du conducteur (3) au niveau d'une première surface de carte de circuit imprimé (51) de la carte de circuit imprimé (5), dans lequel
- l'élément de positionnement (9) peut être relié à la carte de circuit imprimé (5), **caractérisé en ce que** l'élément de positionnement (9) présente une rainure (94) correspondant à une section de conducteur (33) du conducteur (3), rainure dans laquelle la section de conducteur (33) peut être disposée par complémentarité de formes au niveau de la première surface de carte de circuit imprimé (51), dans lequel
- l'unité de mesure de courant (7) est disposée au niveau d'une seconde surface de carte de circuit imprimé (52) de la carte de circuit imprimé (5) opposée à la première surface de carte de circuit imprimé (51) et la carte de circuit imprimé (5) agit en tant qu'isolant qui isole électriquement le conducteur (3) de l'unité de mesure de courant (7) et définit l'écart de l'unité de mesure de courant (7) au conducteur (3).

2. Dispositif de mesure (1) selon la revendication 1, dans lequel la carte de circuit imprimé (5) présente au moins une ouverture de carte de circuit imprimé (53) et l'élément de positionnement (9) présente au moins un renfoncement (97) correspondant à une ouverture de carte de circuit imprimé (53), renfoncement dans lequel pour la liaison de l'élément de positionnement (9) à la carte de circuit imprimé (5) un élément de liaison (21) guidé à travers l'ouverture de carte de circuit imprimé (53) peut être fixé par complémentarité de forces et/ou par complémentarité de formes.

3. Dispositif de mesure (1) selon la revendication 2, dans lequel chaque renfoncement (97) de l'élément de positionnement (9) est bordé par un col (98) qui peut être introduit dans l'ouverture de carte de circuit imprimé (53), à laquelle correspond le renfoncement (97).

4. Dispositif de mesure (1) selon la revendication 3, dans lequel au niveau de chaque col (98) bordant un renfoncement (97) sont disposées des nervures de col (99) déformables qui sont déformées lors de la liaison de l'élément de positionnement (9) à la carte de circuit imprimé (5) par un bord d'ouverture (54) de la carte de circuit imprimé (5) bordant l'ouverture de carte de circuit imprimé (53), à laquelle correspond le renfoncement (97).

5. Dispositif de mesure (1) selon l'une quelconque des revendications précédentes, dans lequel l'unité de mesure de courant (7) est disposée dans une zone de la carte de circuit imprimé (5) au niveau de laquelle sera positionné le conducteur (3).

6. Dispositif de mesure (1) selon l'une quelconque des revendications précédentes, dans lequel les détecteurs de courant (9) sont des détecteurs détectant des champs magnétiques.

7. Dispositif de mesure (1) selon l'une quelconque des revendications précédentes, dans lequel au niveau d'un fond de rainure (94.6) de la rainure (94) sont disposées des nervures de rainure (94.7) déformables qui sont déformées lors de la liaison de l'élément de positionnement (9) à la carte de circuit imprimé (5) par la section de conducteur (33) du conducteur (3) positionnée dans la rainure (94).

8. Dispositif de mesure (1) selon l'une quelconque des revendications précédentes, dans lequel la rainure (94) présente dans l'élément de positionnement (9) au niveau de chaque extrémité de rainure (94.1, 94.2) une profondeur de rainure plus grande que dans une zone centrale de rainure (94.3) s'étendant entre les extrémités de rainure (94.1, 94.2) et la section de conducteur (33) du conducteur (3) présente une hauteur de section de conducteur correspondant à la profondeur de rainure qui est plus grande que la profondeur de rainure conformément à chaque extrémité de section de conducteur (33.1, 33.2) par rapport à dans une zone centrale de section de conducteur (33.3) s'étendant entre les extrémité de section de conducteur (33.1, 33.2).

9. Dispositif de mesure (1) selon l'une quelconque des revendications précédentes, dans lequel l'élément de positionnement (9) présente dans une zone adjacente à une extrémité de rainure (94.1) de la rainure (94) une goupille de positionnement (95) qui correspond à une cavité de conducteur (32) dans le conducteur (3) et fait saillie dans la cavité de conducteur (32) lorsque la section de conducteur (33) du conducteur (3) est disposée dans la rainure (94).

10. Dispositif de mesure (1) selon l'une quelconque des revendications précédentes, dans lequel la rainure (94) et la section de conducteur (33) présentent respectivement une section transversale rectangulaire.

11. Dispositif de mesure (1) selon l'une quelconque des revendications précédentes, dans lequel un détecteur de tension (17) est disposé au niveau de ou dans la carte de circuit imprimé (5), lequel détecteur est conçu pour la détection d'une tension électrique appliquée au conducteur (3).

12. Dispositif de mesure (1) selon l'une quelconque des revendications précédentes avec un blindage magnétique (13).

13. Dispositif de mesure (1) selon l'une quelconque des revendications précédentes avec un blindage électrique (15) qui est disposé dans la carte de circuit imprimé (5) entre l'unité de mesure de courant (7) et la position prévue pour le conducteur (3).

14. Dispositif de mesure (1) selon l'une quelconque des revendications précédentes avec une unité de traitement de signaux de mesure (19) qui est conçue pour traiter des signaux de mesure détectés par l'unité de mesure de courant (7) .
